# EUROPEAN PATENT SPECIFICATION

(11) **EP 0 831 535 B1**
(45) Date of publication and mention of the grant of the patent: **31.08.2005**
(21) Application number: 96114741.0
(22) Date of filing: 13.09.1996
(51) Int. Cl.: H01L 31/00, H01L 27/146, H01L 31/024

(54) **Hybrid focal plane array stabilization and isolation scheme**
Stabilisierung und Isolation einer hybriden Bildebene-Matrix
Stabilisation et isolation d'un réseau hybride à plan focal

(43) Date of publication of application: 25.03.1998
(73) Proprietor: DRS Sensors & Targeting Systems, Inc., Anaheim, CA 92803 (US)
(72) Inventor: Asatourian, Rolin K., Fullerton, California 92633 (US)
(74) Representative: Geyer, Ulrich F.

(56) References cited:
- DD-A- 299 405
- US-A- 4 660 066
- US-A- 4 943 491
- US-A- 5 308 980
- US-A- 5 365 088
- US-A- 5 382 797
- PATENT ABSTRACTS OF JAPAN vol. 95, no. 008 & JP 07 218335 A (TOSHIBA CORP), 18 August 1995,

## Description

### 1. Field of the Invention

The present invention relates to stabilizing and supporting a focal plane array (FPA) on a cooling platform. More particularly, the present invention provides for enhanced reliability of the FPA throughout thermal cycling processes during which temperature-induced contraction and expansion between dissimilar materials comprising the FPA may significantly vary.

### 2. Description of Related Art

A further discussion of FPA mounting and stiffening techniques is described in copending application entitled "Hybrid Focal Plane Array Stabilizing Apparatus And Method," US Patent No. 5 585 624, issued Dec. 17, 1996, and invented by R.K. Asatourian, D.E. Cooper, W.L. Morris, and M.R. James.

Hybrid FPAs, by definition, are formed of a variety of different materials having differing coefficients of thermal expansion. Accordingly, the conventional layering scheme of such FPAs often causes the materials incorporated in the FPA to be distorted and deflected as the result of the potentially wide changes in temperatures applied to the FPA.

FPAs typically include several different layers of materials, such as an optical substrate layer coated with an optically-sensitive material, an interconnecting scheme typically formed of pliable conducting bumps, and an electronic means, such as a multiplexer (MUX) layer which includes the FPA electronics. The above-described materials of the FPA are mounted on a platform or base in a layered arrangement. The system is cooled by cooling the mounting platform which, in turn, cools the FPA. Infrared radiation enters the optical substrate layer and is detected by the layer of optically-sensitive material.

However, like any system of dissimilar materials exposed to thermal excursions, the FPA and its mounting configuration must meet predetermined thermal cycling reliability objectives of a particular application. If temperature variations are sufficiently great and the thermal expansion coefficients (TECs) of the materials used in the FPA are substantially different, damage to the interconnection scheme between each of the layers of the FPA and the optically sensitive material can occur after a number of cycles.

For example, the hybrid interface of the FPA, e.g., the interconnecting bumps between the detector layer and the MUX, is pliable and thermal contraction can damage these interconnections which form the electrical and mechanical contacts for each pixel of the FPA. Large strains on the interconnect bumps may break the connections, opening the electrical contact between the two layers. Stresses in this region can also lead to damage of the optically sensitive detector layer, reducing its photo-response and increasing the noise.

More particularly, with regard to lateral, or in-plane, deformations of the interconnect bumps, it has been found that such deformations are typically caused by the difference in the contraction rate of the hybrid FPA components. In addition to in-plane deformation, such contraction rate differences can induce out-of-plane forces on the FPA leading to bowing of the FPA. For example, in a typical hybrid FPA in which the detector material has a TEC higher than the MUX, the hybrid FPA will assume a concave deflection or bow when cooled.

Furthermore, this undesirable bowing may be affected by the mounting of the hybrid FPA on a supporting platform, such as the cold plate of a dewar. The deformations experienced by the mounting platform may then be transmitted to the FPA, and may increase or decrease the FPA bow depending on the direction of deflection of the platform. More particularly, the distortions and deflections experienced by the FPA may potentially be further increased by deflections and distortions that the platform itself experiences when it is cooled down. Thus, due to the mismatch of TECs of various layers in the FPA and the platform, as well as the deflections of the platform itself, the interconnect bumps may experience both an in-plane and an out-of-plane deformation leading to their work-hardening, and eventual fracture or separation.

One approach used to reduce damage to the interconnect bumps has been to back-fill the space between the MUX and the detector with epoxy. This epoxy takes some of the mechanical load off the bumps, and helps to hold the MUX and the detector layers together, thereby reducing bump damage. However, the back-fill epoxy, which generally has a TEC that is higher than both the MUX and the optical substrate forming the detector, also has a tendency to produce lateral tension on the bumps. Since the epoxy adheres to the surface of the optically sensitive material, it tends to strain the layer and degrade its characteristics.

In another approach, the MUX is forced to comply with the TEC of the detector optical substrate by mounting a thin MUX on a rigid material which has a TEC which matches that of the detector substrate. Although this approach tends to be less stressful on the optically sensitive material, certain practical challenges are introduced when the MUX circuitry and interconnect bumps are processed on a thin layer, or when the MUX layer is thinned after the electronic circuitry and bumps have been fabricated. In addition, functionality problems have been observed in thin MUXs where the electronic circuitry is subjected to extremely high stress levels both from the thinning process and from the compressive force during cooling. Neither of these approaches are immune to the impact of platform deflections.

Attention is also drawn to the US-patent 4,943,491, which discloses an improved structure for interconnecting focal plane arrays. A first body having a first coefficient of expansion comprising a detector array is connected by interconnection apparatus to a second body having a second coefficient of expansion. The second body comprises semiconductor electronics and includes a bottom surface which opposes the surface connected to the first body. A layer of material is bonded with an adhesive to the second body's bottom surface wherein the bonded layer has a third coefficient of expansion which is greater than the first and second coefficients of expansion. In one aspect of the invention, the interconnection apparatus comprises interconnect columns made substantially of indium, the second body is substantially comprised of silicon and the first body is substantially comprised of material selected from the group consisting of CdTe and HgCdTe. The bonded layer may advantageously be substantially comprised of copper.

Furthermore, attention is drawn to the DD 299 405, which discloses a double row of integrated single detectors made of different, but related detector materials which are sensitive to infrared radiation. The detectors are coupled in a hybrid manner with one or two adapted Si read-out arrays and provide for a real time infrared image recording and reproduction when combined with the necessary optical, cryo-technical and electronical elements.

In accordance with the present invention a hybrid focal plane array structure for processing radiation, as set forth in claim 1, and a method for manufacturing a hybrid focal plane array, as set forth in claim 14, is provided. Preferred embodiments of the invention are disclosed in the dependent claims.

### SUMMARY OF THE INVENTION

Accordingly, it is an object of the present invention to improve the reliability of a FPA by configuring the FPA mounting arrangement to substantially reduce and limit the amount of distortion and deflection of the materials used in the FPA. In particular embodiments, the present invention is directed to minimizing in-plane and out-of-plane forces on the bumps and the detector of a hybrid FPA.

These and other objectives are accomplished, according to an embodiment of the present invention, by a hybrid FPA arrangement in which temperature excursions do not affect or degrade the performance of the FPA which includes several layers of different materials having different TECs. The hybrid FPA includes an optical substrate with a layer of an optically sensitive material grown on one surface of the substrate. The optically sensitive side of the substrate layer is electrically and mechanically coupled to a MUX chip using interconnection bumps.

The MUX may be combined with other materials, and is constructed to balance the contraction of the optical substrate when cooled. The thickness of the MUX structure is determined such that the MUX structure exhibits an effective TEC which substantially matches that of the optical substrate. To prevent disruption of the symmetrical balance, as well as the TEC match between the MUX structure and the optical substrate, the MUX structure is mechanically isolated from the platform upon which it is mounted to the extent allowed by the cool down requirements of the particular application. Accordingly, the BCS is mounted onto a platform or dewar cold plate with a pliable, thick epoxy which is limited in area to control and reduce the mechanical coupling to the platform.

### BRIEF DESCRIPTION OF THE DRAWINGS

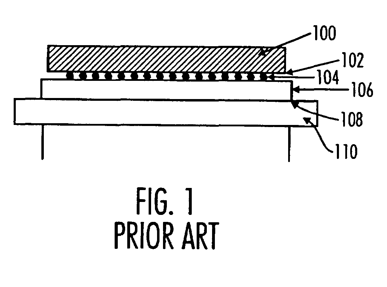

Figure 1 is a cross-sectional view of a conventional focal plane array.
Figure 2 is a cross-sectional view of a hybrid focal plane array in accordance with a preferred embodiment of the present invention.
Figure 3 is a cross-sectional view of a hybrid focal plane array in accordance with an alternate embodiment of the present invention.

### DETAILED DESCRIPTION OF THE PREFERRED EMBODIMENTS

The following description is of the best presently contemplated mode of carrying out the invention. In the accompanying drawings, like numerals designate like parts in the several figures. This description is made for the purpose of illustrating the general principles of the invention and should not be taken in a limiting sense.

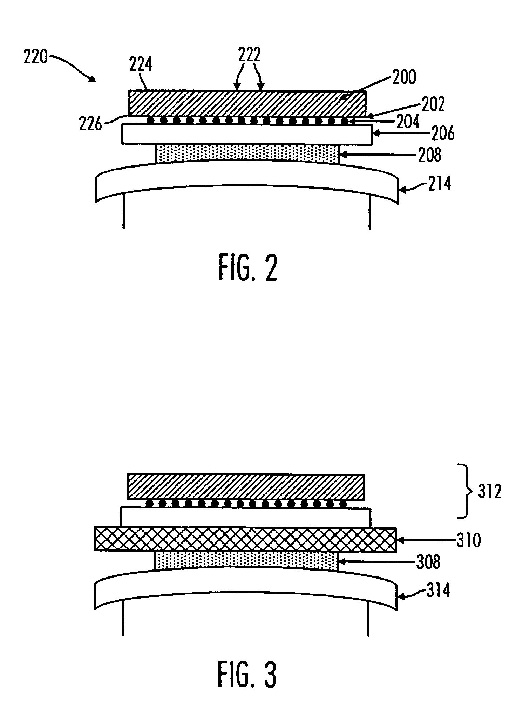

A cross-section of a hybrid FPA in accordance with a preferred embodiment of the present invention is indicated in Figure 2 as reference numeral 220. In the illustrated FPA, light 222 represented as infrared radiation impinges on the surface 224 of an optical substrate 200. The optical substrate is preferably formed of sapphire, or other substances of appropriate transmittance at desired wavelengths. Such wavelengths may cover a certain desired range of the infrared spectrum. For example, in preferred embodiments, the sapphire optical substrate 200 is approximately 0,03302 cm (0.013 inch) thick. The size of the detector optical substrate 200 may vary depending upon the number of pixels in the array, e.g., 128 x 128 and 1024 x 1024.

The lower surface 226 of the detector 200 is coated with a thin layer of an optically sensitive material 202. The optically sensitive material 202 is provided to convert photons into electric charge. This electric charge is conducted through an interconnection scheme 204 to a multiplexer (MUX) chip 206. According to preferred embodiments of the present invention, the interconnection scheme 204 is formed by a pair of interconnect "bumps" per pixel. Each interconnect bump is made of a soft, pliable conducting material such as indium (In). One of the bumps in each pair is grown on the detector 200/202, and the other is coupled to the MUX 206 at each pixel location. The shape, size and pitch of the bumps may vary depending on the particular application. The MUX 206 and the detector 200 are then mated together in the process of the hybrid FPA fabrication such that each bump on the detector side is aligned with and squashed against the corresponding bump on the MUX side, establishing mechanical as well as an electrical connection.

Preferably, the optically sensitive material 202 comprises a Mercury-Cadmium-Telluride (HgCdTe) compound on a buffering Cadmium-Telluride (CdTe) compound which are grown on the lower surface 226 of the detector optical substrate 200. The photons detected by the HgCdTe layer are converted into electrical charge and transferred through the In bumps to the MUX 206. The MUX is preferably formed of a silicon (Si) substrate or other semiconducting material, such as gallium arsenide (GaAs), appropriate for fabricating integrated circuits. The MUX 206 contains integrated circuits necessary to convert the electrical charge generated from the incoming photons at each pixel location to an appropriate electrical signal, and to clock out the signals from various pixels in an organized scheme. It will be recognized, however, that the materials and configuration of the MUX substrate, the number of output channels, the signal characteristics, the clocking scheme and its speed will vary depending upon the particular application.

In operation, the FPA 220 is cooled down to cryogenic temperatures every time it is used by coupling the detector 200, bumps 204, and MUX 206 layers to a cold source 214, such as a cryostat-cooled ceramic cold plate or dewar. Consequently, when the cold source 214 remains in contact with the FPA layers, the FPA can be cooled down. During its lifetime, the FPA is exposed to a number of thermal cycles between ambient and cryogenic temperatures. The number of cycles depends on the particular application. In some applications it is desirable that the FPA be able to survive thousands of thermal cycles with little degradation. Therefore, the FPA must be constructed to maintain its mechanical integrity and electrical functionality as it is cooled down repeatedly. However, it is recognized that the larger the hybrid FPA, the higher the stresses caused by the mismatch of TECs of various layers, especially at the edges and corners of the structure, as illustrated in Figure 2. Thus, it has been found that the practical size of a hybrid FPA is limited by reliability problems relating to the mismatch of TECs of various layers.

However, in addition to being able to withstand thermal stresses generated by TEC mismatch of layers within its structure, the FPA 220 must survive stresses and other distorting effects generated by the mounting platform 214 or cold plate which are transmitted through the bonding material which is used to mount the FPA onto the platform 214. The mounting platform 214 itself may experience deflections and distortions when cooled down due to its construction, its own supporting material, and the manner in which it is attached to its supporting structure (not shown). For example, the supporting material could be a cold well which houses a cooling device, such as a cryostat, or a well for filling liquid cryogen.

Mechanical coupling to the mounting platform 214 may, in some instances, be beneficial for hybrid FPA reliability. An intimate coupling of the MUX 206 with a non-compliant epoxy to the platform 214 may be used to cause the MUX material to exhibit a TEC close to that of the optical substrate 202 if the TEC of the platform material is similar to that of the optical substrate 202 and, furthermore, if the platform itself does not exhibit excessive deflections when cooled. However, if the materials used in the construction of the FPA and the platform are such that this benefit is not realized, a close mechanical coupling may have a harmful impact on the FPA reliability.

Consequently, in preferred embodiments of the invention, a reduced mechanical coupling to the platform 214 is implemented where the TECs of the MUX structure 206 and the optical substrate 202 are closely matched, or when the hybrid FPA is stabilized using a carrier of single or multiple layers, such that the MUX exhibits a TEC similar to that of the optical substrate. In both instances, a close coupling to the mounting platform may potentially disrupt this stability, yet the hybrid FPA can remain substantially stable.

Thus, it is often desirable to utilize a particular bonding configuration of the FPA 220 to the platform 214 that provides some degree of mechanical isolation. In a preferred embodiment of this invention, the bonding to the platform 214 is accomplished by applying a pliable, thick bonding material 208 to a limited area. The type of bonding epoxy used, its thickness, and its area are selected to minimize distortion and deflection of the FPA, yet also to provide sufficient thermal conduction, and adequate shock and vibration survivability to satisfy specific requirements of each particular application. For example, it has been observed that proper isolation can be achieved by using a Sylgard epoxy, approximately 6 mm in diameter and 180 microns in height. It will be recognized, however, that the materials used, as well as the dimensions of such materials, may vary depending on the type of epoxy, adhesive, or attachment device used to mount the hybrid FPA to a platform.

Referring to Figure 3, the hybrid FPA structure 312 is mounted on a carrier 310 which is coupled to the platform 314. The carrier 310 may be implemented for purposes of geometry or handling. Preferably, the carrier 310 is mounted between the MUX (206 in Figure 2) and the platform 314 using a soft, thick, localized epoxy 308. The material of the carrier 310 is preferably selected to provide adequate thermal conductance to allow conduction of heat into the cold plate 314 at an appropriate rate. Preferably the carried 310 comprises a multiple-layer substrate. It will be recognized that a variety of adhesives may be used to bind the various layers of the FPA together. Adhesives and other coupling means may be selected to satisfy the TEC, modulus, thermal conductance, out-gassing, curing and other mechanical, thermal, chemical, and economic aspects desired in a particular design.

Accordingly, embodiments of the present invention substantially reduce lateral and normal strain on the interconnect bumps and the detector by effectively forcing the TEC of the MUX to match that of the optical substrate without inducing an undesirable bending. The reliability of the hybrid FPA is thus greatly increased.

## Claims

1. A hybrid focal plane array structure (220) for processing radiation comprising:
a detector including
an optical substrate (200) for support of an optically sensitive material and having a first thermal expansion coefficient, and
an optically sensitive layer (202) for conversion of incoming radiation to electrical charge;
electronic means (206) for receiving the electrical charge generated by the optically sensitive layer having a first surface opposite the optical substrate and a second surface parallel to the first surface said means (206) having a second thermal expansion coefficient, wherein the first and second thermal expansion coefficients are matched;
interconnection means (204) for mechanical, electrical and thermal coupling of the electronic means to the detector, such that the radiation detected by the detector is transmitted as electrical signals through the interconnection means to the electronic means;
cooling means (214) for supporting the electronic means and detector, and for cooling the electronic means and detector, wherein the cooling means has a first surface facing the electronic means; and
isolation bonding means (208) for thermally and mechanically coupling the electronic means and the cooling means, wherein the isolation bonding means is pliable and includes first and second major surfaces respectively opposing the electronic means and the first surface of the cooling means and wherein each of the first and second major surfaces is of an area less than the area of the first surface of the cooling means and the second surface of the electronic means.

2. The hybrid focal plane array structure of claim 1, wherein the detector includes a first surface and a second surface, the optically sensitive layer being disposed on the second surface (226) of the detector between the detector and the interconnection means (204), and the radiation being received at the first surface of the detector, further wherein the optically sensitive material absorbs the radiation received by the detector, converts the radiation to electrical charge, and transmits the electrical charge through the interconnection means (204) to the electronic means (206).

3. The hybrid focal plane array of claim 1, wherein the isolation means (208) comprises an epoxy for partially mechanically isolating the electronic means from the cooling means (214).

4. The hybrid focal plane array of claim 1, wherein the detector comprises a crystalline substrate.

5. The hybrid focal plane array of claim 4, wherein the crystalline substrate is formed of sapphire.

6. The hybrid focal plane array of claim 1, wherein the optically sensitive layer (202) comprises mercury-cadmium-telluride and cadmium-telluride compounds.

7. The hybrid focal plane array of claim 1, wherein the interconnection means (204) comprises a pliable, electrically conducting material.

8. The hybrid focal plane array of claim 7, wherein the interconnection means (204) comprises a plurality of indium bumps.

9. The hybrid focal plane array of claim 1, wherein the electronic means (206) includes an electrically conductive network for electrically conducting the electrical charge generated by the optically sensitive layer out of the electronic means (206).

10. The hybrid focal plane array of claim 1, wherein the electronic means (206) comprises:
• electronic circuitry for processing the electrical charge generated by the optically sensitive layer (202)into electrical signals, and
• an electrically conductive network for electrically conducting the electrical signals out of the electronic means (206).

11. The hybrid focal plane array of claim 1, wherein the cooling means (214) comprises a ceramic material.

12. The hybrid focal plane array of claim 1, further comprising a carrier substrate (310) coupled between the electronic means (206) and the isolation means (208).

13. The hybrid focal plane array of claim 12, wherein the carrier substrate (310) comprises a multiple-layer substrate.

14. A method for manufacturing a hybrid focal plane array (FPA) provided with an optical substrate (200) for receiving impinging radiation, wherein the optical substrate supports an optically sensitive layer (202) for converting the radiation to electrical charge and has a first thermal expansion coefficient, and an electronic means (206) coupled to the optical substrate for receiving the electrical charge generated by the optically sensitive layer and having a first surface opposite the optical substrate and a second surface parallel to the first surface and having a second thermal expansion coefficient, wherein the first and second thermal expansion coefficients are matched, the method comprising the steps of:
providing interconnection means (204) to mechanically, electrically and thermally couple the electronic means (206) to the optically sensitive layer such that the radiation converted by the optically sensitive layer is transmitted as electrical signals through the interconnection means to the electronic means; and
• thermally and mechanically coupling the electronic means (206) to a cooling means (214) using a pliable isolation bonding means (208), wherein the cooling means has a first surface facing the electronic means, wherein the isolation bonding means (208) has first and second major surfaces respectively opposing the electronic means and the first surface of the cooling means and wherein each of the first and second major surfaces is of an area less than the area of the first surface of the cooling means and the second surface of the electronic means.

## Patentansprüche

1. Hybrid-Brennebenen-Anordnungsstruktur (220) zur Verarbeitung von Strahlung, wobei die Struktur folgendes aufweist:
einen Detektor, welcher folgendes umfasst:
ein optisches Substrat (200) zum Tragen eines optisch empfindlichen Materials, wobei das optische Substrat einen ersten Wärmeausdehnungskoeffizienten besitzt, und
eine optisch empfindliche Schicht (202) zum Umwandeln von einfallender Strahlung in elektrische Ladung;
elektronische Mittel (206) zum Empfangen der elektrischen Ladung, die von der optisch empfindlichen Schicht erzeugt wurde, wobei die elektronischen Mittel eine erste Oberfläche gegenüberliegend dem optischen Substrat und eine zweite Oberfläche parallel zu der ersten Oberfläche besitzen, wobei die Mittel (206) einen zweiten Wärmeausdehnungskoeffizienten besitzen, wobei die ersten und zweiten Wärmeausdehnungskoeffizienten aneinander angepasst sind;
Verbindungsmittel (204) zum mechanischen, elektrischen und thermischen Koppeln der elektronischen Mittel mit dem Detektor, so dass die von dem Detektor detektierte Strahlung als elektrische Signale durch die Verbindungsmittel an die elektronischen Mittel übertragen wird;
Kühlmittel (214) zum Tragen der elektronischen Mittel und des Detektors und zum Kühlen der elektronischen Mittel und des Detektors, wobei die Kühlmittel eine erste Oberfläche besitzen, die zu den elektronischen Mitteln weist;
Trennungs-Bonding-Mittel oder Isolations-Verbindungsmittel (208) zum thermischen und mechanischen Koppeln der elektronischen Mittel und der Kühlmittel, wobei die Isolations-Verbindungsmittel nachgiebig sind und erste und zweite Hauptoberflächen besitzen, die jeweils den elektronischen Mitteln und der ersten Oberfläche der Kühlmittel gegenüberliegen, und wobei sowohl die erste als auch die zweite Hauptoberfläche eine Fläche besitzt, die geringer ist als die Fläche der ersten Oberfläche der Kühlmittel und die zweite Oberfläche der elektronischen Mittel.

2. Hybrid-Brennebenen-Anordnungsstruktur gemäß Anspruch 1, wobei der Detektor eine erste Oberfläche und eine zweite Oberfläche umfasst, wobei die optisch empfindliche Schicht auf der zweiten Oberfläche (226) des Detektors zwischen dem Detektor und den Verbindungsmitteln (204) angeordnet ist und wobei die Strahlung an der ersten Oberfläche des Detektors empfangen wird, wobei ferner das optisch empfindliche Material die von dem Detektor empfangene Strahlung absorbiert, die Strahlung in elektrische Ladung umwandelt, und die elektrische Ladung durch die Verbindungsmittel (204) an die elektronischen Mittel (206) überträgt.

3. Hybrid-Brennebenen-Anordnungsstruktur gemäß Anspruch 1, wobei die Isolationsmittel (208) ein Epoxid aufweisen zum teilweise mechanischen Isolieren oder Trennen der elektronischen Mittel von den Kühlmitteln (214).

4. Hybrid-Brennebenen-Anordnungsstruktur gemäß Anspruch 1, wobei der Detektor ein kristallines Substrat aufweist.

5. Hybrid-Brennebenen-Anordnungsstruktur gemäß Anspruch 4, wobei das kristalline Substrat aus Saphir gebildet ist.

6. Hybrid-Brennebenen-Anordnungsstruktur gemäß Anspruch 1, wobei die optisch empfindliche Schicht (202) Quecksilber-Cadmium-Tellurid und Cadmium-Tellurid-Verbindungen aufweist.

7. Hybrid-Brennebenen-Anordnungsstruktur gemäß Anspruch 1, wobei die Verbindungsmittel (204) ein nachgiebiges elektrisch leitendes Material aufweisen.

8. Hybrid-Brennebenen-Anordnungsstruktur gemäß Anspruch 7, wobei die Verbindungsmittel (204) eine Vielzahl von Indium-Buckeln aufweisen.

9. Hybrid-Brennebenen-Anordnungsstruktur gemäß Anspruch 1, wobei die elektronischen Mittel (206) ein elektrisch leitendes Netzwerk zum elektrischen Leiten der von der optisch empfindlichen Schicht erzeugten elektrischen Ladung aus den elektronischen Mitteln (206) umfassen.

10. Hybrid-Brennebenen-Anordnungsstruktur gemäß Anspruch 1, wobei die elektronischen Mittel (206) folgendes aufweisen:
eine elektronische Schaltung zum Verarbeiten der von der optisch empfindlichen Schicht (202) erzeugten elektrischen Ladung in elektrische Signale und
ein elektrisch leitendes Netzwerk zum elektrischen Leiten der elektrischen Signale aus den elektronischen Mitteln (206).

11. Hybrid-Brennebenen-Anordnungsstruktur gemäß Anspruch 1, wobei die Kühlmittel (214) ein Keramikmaterial aufweisen.

12. Hybrid-Brennebenen-Anordnungsstruktur gemäß Anspruch 1, die ferner ein Trägersubstrat (310) aufweist, das zwischen den elektronischen Mitteln (206) und den Trenn- bzw. Isolationsmitteln (208) gekoppelt ist.

13. Hybrid-Brennebenen-Anordnungsstruktur gemäß Anspruch 12, wobei das Trägersubstrat (310) ein Mehrschichtsubstrat aufweist.

14. Verfahren zum Herstellen einer Hybrid-Brennebenen-Anordnung (FPA), welche mit einem optischen Substrat (200) zum Empfangen auftreffender Strahlung versehen ist, wobei das optische Substrat eine optisch empfindliche Schicht (202) zum Umwandeln der Strahlung in elektrische Ladung und mit einem ersten Wärmeausdehnungskoeffizienten und elektronische Mittel (206) trägt, die mit dem optischen Substrat gekoppelt sind zum Empfang der von der optisch empfindlichen Schicht erzeugten elektrischen Ladung und mit einer ersten Oberfläche gegenüberliegend dem optischen Substrat und einer zweiten Oberfläche parallel zu der ersten Oberfläche und mit einem zweiten Wärmeausdehnungskoeffizienten, wobei der erste und der zweite Wärmeausdehnungskoeffizient aneinander angepasst sind, wobei das Verfahren die folgende Schritte aufweist:
Vorsehen von Verbindungsmitteln (204) zum mechanischen, elektrischen und thermischen Koppeln der elektronischen Mitteln (206) mit der optisch empfindlichen Schicht, und zwar derart, dass die von der optisch empfindlichen Schicht umgewandelte Strahlung als elektrische Signale durch die Verbindungsmittel an die elektronischen Mittel übertragen wird; und
thermisches und mechanisches Koppeln der elektronischen Mittel (206) mit Kühlmitteln (214) unter Verwendung von nachgiebigen Isolations-Verbindungsmitteln oder Trennungs-Bonding-Mitteln (208), wobei die Kühlmittel eine erste Oberfläche besitzen, die zu den elektronischen Mitteln weist, wobei die Isolations-Verbindungsmittel (208) erste und zweite Hauptoberflächen besitzen, die den elektronischen Mitteln bzw. der ersten Oberfläche der Kühlmittel gegenüberliegen, und wobei jede der ersten und zweiten Hauptoberflächen eine geringere Fläche besitzt als die Fläche der ersten Oberfläche der Kühlmittel und die zweite Oberfläche der elektronischen Mittel.

## Revendications

1. Structure de réseau hybride dans le plan focal (220) pour traiter un rayonnement comprenant :
un détecteur comprenant :
un substrat optique (200) pour porter un matériau photosensible et ayant un premier coefficient de dilatation thermique, et
une couche photosensible (202) pour convertir le rayonnement incident en charge électrique ;
un moyen électronique (206) pour recevoir la charge électrique produite par la couche photosensible ayant une première face opposée au substrat optique et une seconde face parallèle à la première face et ayant un second coefficient de dilatation thermique, dans lequel les premier et second coefficients de dilatation thermique sont adaptés ;
un moyen d'interconnexion (204) pour assurer un couplage mécanique, électrique et thermique du moyen électronique et du détecteur, de sorte que le rayonnement détecté par le détecteur est transmis sous forme de signaux électriques par le moyen d'interconnexion au moyen électronique ;
un moyen de refroidissement (214) pour porter le moyen électronique et le détecteur et pour refroidir le moyen électronique et le détecteur, le moyen de refroidissement ayant une première face tournée vers le moyen électronique ; et
un moyen de liaison isolant (208) pour coupler thermiquement et mécaniquement le moyen électronique et le moyen de refroidissement, le moyen de liaison isolant étant pliable et comprenant des première et seconde faces principales respectivement opposées au moyen électronique et à la première face du moyen de refroidissement, et chacune des première et seconde faces principales ayant une surface inférieure à la surface de la première face du moyen de refroidissement et de la seconde face du moyen électronique.

2. Structure de réseau hybride dans le plan focal selon la revendication 1, dans laquelle le détecteur a une première face et une seconde face, la couche photosensible étant disposée sur la seconde face (226) du détecteur entre le détecteur et le moyen d'interconnexion (204), et le rayonnement étant reçu au niveau de la première face du détecteur, dans lequel en outre le matériau photosensible absorbe le rayonnement reçu par le détecteur, convertit le rayonnement en charge électrique, et transmet la charge électrique par l'intermédiaire du moyen d'interconnexion (204) au moyen électronique (206).

3. Réseau hybride dans le plan focal selon la revendication 1, dans lequel le moyen isolant (208) comprend un matériau époxy pour isoler partiellement mécaniquement le moyen électronique du moyen de refroidissement (214).

4. Réseau hybride dans le plan focal selon la revendication 1, dans lequel le détecteur comprend un substrat cristallin.

5. Réseau hybride dans le plan focal selon la revendication 4, dans lequel le substrat cristallin est en saphir.

6. Réseau hybride dans le plan focal selon la revendication 1, dans lequel la couche photosensible (202) comprend des composés de tellurure de mercure-cadmium et de tellurure de cadmium.

7. Réseau hybride dans le plan focal selon la revendication 1, dans lequel le moyen d'interconnexion (204) comprend un matériau pliable électriquement conducteur.

8. Réseau hybride dans le plan focal selon la revendication 7, dans lequel le moyen d'interconnexion (204) comprend une pluralité de bossages en indium.

9. Réseau hybride dans le plan focal selon la revendication 1, dans lequel le moyen électronique (206) comprend un réseau électriquement conducteur pour conduire électriquement les charges électriques produites par la couche photosensible en dehors du moyen électronique (206).

10. Réseau hybride dans le plan focal selon la revendication 1, dans lequel le moyen électronique (206) comprend :
un circuit électronique pour traiter la charge électrique produite par la couche photosensible (202) sous forme de signaux électriques, et
un réseau électriquement conducteur pour conduire électriquement les signaux électriques en dehors du moyen électronique (206).

11. Réseau hybride dans le plan focal selon la revendication 1, dans lequel le moyen de refroidissement (214) comprend un substrat de céramique.

12. Réseau hybride dans le plan focal selon la revendication 1, comprenant en outre un substrat support (310) couplé entre le moyen électronique (206) et le moyen isolant (208).

13. Réseau hybride dans le plan focal selon la revendication 12, dans lequel le substrat support (310) comprend un substrat multicouche.

14. Procédé de fabrication d'un réseau hybride dans le plan focal (FPA) muni d'un substrat optique (200) pour recevoir un rayonnement incident, dans lequel le substrat optique porte une couche photosensible (202) pour convertir le rayonnement en charge électrique et a un premier coefficient de dilatation thermique et un moyen électronique (206) couplé au substrat optique pour recevoir les charges électriques produites par la couche photosensible ayant une première face opposée au substrat optique et une seconde face parallèle à la première face et ayant un second coefficient de dilatation thermique, les premier et second coefficients de dilatation thermique étant accordés, le procédé comprenant les étapes suivantes :
prévoir un moyen d'interconnexion (204) pour coupler mécaniquement, électriquement et thermiquement le moyen électronique (206) à la couche photosensible de sorte que le rayonnement converti par la couche photosensible est transmis sous forme de signaux électriques par l'intermédiaire du moyen d'interconnexion vers le moyen électronique ; et
coupler thermiquement et mécaniquement le moyen électronique (206) à un moyen de refroidissement (214) en utilisant un moyen de liaison isolant pliable (208), le moyen de refroidissement ayant une première face tournée vers le moyen électronique, le moyen de liaison isolant (208) ayant des première et seconde faces principales respectivement tournées vers le moyen électronique et la première face du moyen de refroidissement, et chacune des première et seconde faces principales ayant une surface inférieure à la surface de la première face du moyen de refroidissement et de la seconde face du moyen électronique.
